# EUROPEAN PATENT APPLICATION

(11) **EP 2 466 321 A1**
(43) Date of publication of application: **20.06.2012**
(21) Application number: 11192681.2
(22) Date of filing: 08.12.2011
(51) Int. Cl.: G01R 29/08, F03D 11/00

(54) **System, method and apparatus for detecting lightning strikes**

(30) Priority: 15.12.2010 US 968461
(71) Applicant: General Electric Company, Schenectady, NY 12345 (US)
(72) Inventor: Iannotti, Joseph Alfred, Niskayuna, NY York 12309 (US); Koste, Glen, Niskayuna, NY 12309 (US); Gawrelski, Richard Joseph, Niskayuna, NY 12309 (US); Dufel, Kevin Earl, Niskayuna, NY 12309 (US); Biel, Patrick Jay, Niskayuna, NY 12309 (US)
(74) Representative: Bedford, Grant Richard

(57) **Abstract**

According to an example embodiment of the invention, a method for determining a lightning strike event, classification, and location is provided. The method includes receiving lightning electrical current in least one down conductor (202), generating (204,206,208) voltage and polarity signals based at least in part on the received lightning electrical current, storing (224) the generated voltage and polarity signals, and determining (226) the lightning strike event, classification, and location based at least in part on the stored voltage and polarity signals.

## Description

### FIELD OF THE INVENTION

This invention generally relates to lightning strikes, and in particular, to systems, methods, and apparatus for detecting lightning strikes.

### BACKGROUND OF THE INVENTION

Wind turbines can be relatively tall structures that may be susceptible to lightning strikes. Lightning rods and similar devices may provide a certain protections against lightning strikes, but a powerful strike can still damage many components associated with the wind turbine. High currents may be conducted to or from ground through the wind turbine along various paths and entry/exit points that can depend on complex ionization conditions, potentials, cloud positions, etc. Therefore, various forms of damage can result depending on the intensity, entry/exit position, and current conduction path. For example, lightning strikes can destroy electronic components and delaminate wind turbine blade materials, which can create unsafe operating conditions or failure of the turbine.

When a structure such as a wind turbine is hit by lightning, a damage assessment is often required and service personnel are be dispatched into the field to perform manual inspection of the blades and associated hardware. The blades are typically large hollow structures that can be accessed from the main turbine hub. Two service personnel are generally required for inspection: one to control the blade position and pitch, while the other one enters and inspects the inside of the blade for damage, delamination, cracking, etc. The process of positioning and inspecting each blade of the wind turbine can be a time consuming and expensive process.

A need remains for improved systems, methods, and apparatus for detecting lightning strikes.

### BRIEF SUMMARY OF THE INVENTION

Some or all of the above needs may be addressed by certain embodiments of the invention. Certain embodiments of the invention may include systems, methods, and apparatus for detecting lightning strikes.

According to an example embodiment of the invention, a method is provided for determining a lightning strike event, classification, and location. The method includes receiving lightning electrical current in least one down conductor, generating voltage and polarity signals based at least in part on the received lightning electrical current, storing the generated voltage and polarity signals, and determining the lightning strike event, classification, and location based at least in part on the stored voltage and polarity signals.

According to another example embodiment, a system is provided for determining a lightning strike event, classification, and location. The system includes at least one wind turbine blade, a down conductor associated with the at least one wind turbine blade and operable for receiving lightning electrical current, a resistive element configured for producing voltage and polarity signals from the lightning electrical current, at least one capacitive element configured for storing the voltage and polarity signals, an electrical to optical converter configured to produce an optical signal based at least in part on the stored voltage and polarity signals; and an optical receiver for receiving the optical signal.

According to another example embodiment, an apparatus is provided for determining a lightning strike event, classification, and location. The apparatus includes a down conductor associated operable for receiving lightning electrical current, a resistive element configured for producing voltage and polarity signals from the lightning electrical current, at least one capacitive element configured for storing the voltage and polarity signals, an electrical to optical converter configured to produce an optical signal based at least in part on the stored voltage and polarity signals, and an optical receiver for receiving the optical signal.

According to another example embodiment of the invention, a method is provided for determining a lightning strike event, classification, and location. The method includes receiving lightning electrical current in least one down conductor, conducting the received lightning electrical current through a series circuit comprising a first shunt having a first resistivity and a second shunt having a second resistivity, where the first and second resistivities are unequal. The method also includes generating a first voltage signal and a second voltage signal from the first shunt and the second shunt respectfully based at least in part on the received lightning electrical current, measuring a difference signal between the first voltage signal and the second voltage signal, and determining the lightning strike event, classification, and location based at least in part on the measured difference signal. The method may also include generating the first voltage signal and the second voltage signal based on conducting the received lightening current through the first shunt and the second shunt elements, where the first shunt and the second shunt elements comprise substantially equal geometries or inductances.

Other embodiments and aspects of the invention are described in detail herein and are considered a part of the claimed invention. Other embodiments and aspects can be understood with reference to the following detailed description, accompanying drawings, and claims.

### BRIEF DESCRIPTION OF THE FIGURES

Reference will now be made to the accompanying tables and drawings, which are not necessarily drawn to scale, and wherein:
FIG. 1 is an illustrative wind turbine, according to an example embodiment of the invention.
FIG. 2 is a block diagram of an illustrative lightning detection apparatus and system according to an example embodiment of the invention.
FIG. 3 is an illustrative schematic of a lightning detector circuit according to an example embodiment of the invention.
FIG. 4 is a diagram of a differential shunt circuit according to an example embodiment of the invention.
FIG. 5 is a block diagram of an example shunt detection circuit according to an example embodiment of the invention.
FIG. 6 is a flow diagram of an example method according to an example embodiment of the invention.

### DETAILED DESCRIPTION OF THE INVENTION

Embodiments of the invention will be described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. Like numbers refer to like elements throughout.

Certain embodiments of the invention may enable the detection of a lightning strike event or events. According to certain example embodiments, the invention may also enable classifying the lightning strike event. For example, the detection system may provide information such as lightning location, polarity, and peak current. According to example embodiments, the detection system may be utilized to determine which part of a structure has been hit by lightning. For example, current may travel primarily through one turbine blade when a wind turbine is struck by lightning. In an example embodiment, each turbine blade may be configured with a detector so that inspection resources may be directed primarily to blade that was hit. According to certain example embodiments of the invention, the classification of the lightning strike current and polarity may be utilized further to determine if manual inspection for damage is necessary or not.

According to example embodiments of the invention, one or more batteries may be utilized for powering the lightning detection and communications circuits. In example embodiments, the lightning detection system may include circuits that consume little or no power until a lightning strike has been detected. For example, the invention may include subsystems or circuits that are configured to "wake-up" upon a lightning strike and may provide power to various relays, differential amplifiers, analog to digital converters, communication systems, etc. In example embodiments, once the lightning strike information has been processed, the circuits may power back down until the next lightning strike. According to example embodiments of the invention, the "on-demand" processing of the lightning strike information may enable remote monitoring, conservation of battery power, and may provide certain advantages in terms of installation, particularly in configurations where on-line power is not readily available.

Lightning strikes can create electromagnetic interference (EMI) that can alter or corrupt communications between devices. For example, EMI can induce unwanted current in certain circuits, and can create severe noise in data channels. According to example embodiments of the invention, the polarity and approximate magnitude of current from a lightning strike may be measured and stored in a memory device during the strike. Then, according to an example embodiment, after a predefined period, the stored information may be read from the memory device and transmitted to a base station, for example, to avoid processing or sending information during times of high EMI. In certain example embodiments, the memory device may be a capacitor. For example, current from the lightning strike may be utilized to charge up the capacitor, and the voltage from the charged capacitor may be read, buffered, converted, and transmitted, etc. after the lightning strike, and/or after the on-demand power circuits mentioned above have been energized.

According to example embodiments of the invention, various circuits, systems, and machine-readable instructions for detecting lighting and communicating information about the lightning strike, will now be described with reference to the accompanying figures.

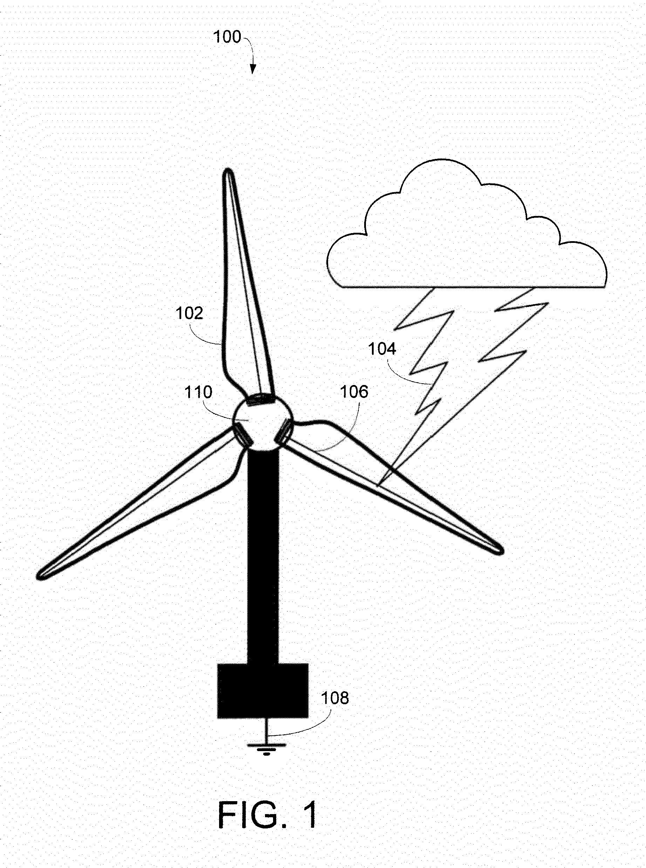

FIG. 1 illustrates an example wind turbine system 100 according to an example embodiment of the invention. The wind turbine system 100 may include one or more blades 102. According to an example embodiment of the invention, the one or more blades 102 may be attached to a hub 110 of a wind turbine structure, and the blades 102 may include a down conductor 106 that may provide a current path for the lightning 104. In an example embodiment, the down conductor 106 may provide a conduction path for conducting lightning current through the blade and to (or from) earth ground 108. According to example embodiments of the invention, lightning-induced current flowing in the down conductor may be detected near the blade-hub connection, and the lightning current information may be transmitted to a stationary receiver mounted on a stationary portion within the hub 110.

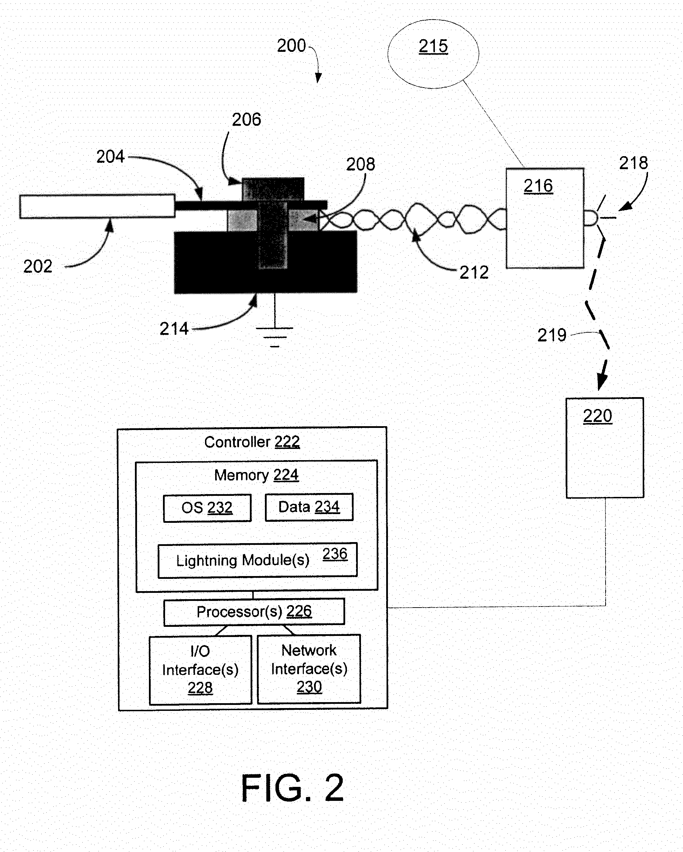

FIG. 2 illustrates an example lightning detection system 200, according to example embodiments of the invention. Certain example embodiments of the system 200 may include a down conductor 202. In an example embodiment, portions of the down conductor 202 may be covered with insulation. In an example embodiment, a portion of the down conductor 204 may have the insulation removed for conductive attachment to a resistive element. According to one example embodiment, the non-insulated portion of the down conductor 204 may be attached and in electrical contact with a first end of a resistive element such as a bolt 206. According to an example embodiment, the bolt may be made from a resistive material such as Nichrome. In this example embodiment, the second end of the Nichrome bolt 206 may attach to a ground connection 214. In an example embodiment, an insulated washer 208 may provide separation between the down conductor 204 and the ground connection 214 so that current can flow through a pre-determined length of the Nichrome bolt 206 before reaching the ground connection 214. In this example embodiment, the current flowing through the Nichrome bolt 206 may produce a voltage drop from the down conductor 204 to the ground connection 214 and the voltage drop may be monitored (via leads 212) by the lightning measurement system and transmitter 216.

According to another example embodiment, the bolt 206 may be electrically insulated from the down conductor 204 and the washer 208 may be resistive (for example, made from Nichrome material). In this example embodiment, a first end or face of the washer 208 may be in electrical contact with the down conductor 204, and the second end or face of the washer 208 may be in electrical contact with the ground connection 214. In this example embodiment, current flowing through the down conductor 204 may travel through a predetermined length of the washer 208. In an example embodiment, the resulting voltage drop across the washer 208 may be monitored (via leads 212) by the lightning measurement system and transmitter 216.

FIG. 2 also depicts an embodiment including a wake-up circuit 215. The wake up circuit 215 may be activated by electromagnetic energy associated with a lightning strike. According to an example embodiment, the wake up circuit 215 may provide a signal to the lightning measurement system and transmitter 216 for waking-or powering-up. As mentioned above, and according to an example embodiment, upon waking-up the lightning measurement system and transmitter 216 may read a stored value of the voltage drop measured across washer 208. According to an example embodiment, the lightning measurement system and transmitter 216 may measure the stored analog voltage. According to an example embodiment, the lightning measurement system and transmitter 216 convert the stored analog voltage to a digital value via an analog to digital converter. According to an example embodiment, the lightning measurement system and transmitter 216 may transmit an analog or digital representation of the stored analog voltage via a light emitting diode 218 to a receiver 220. In an example embodiment, the lightning measurement system and transmitter 216 may include multiple modules, relay, etc, and may include a separate transmitter. In an example embodiment, the transmitter and receiver 218 may communicate via a galvanically isolated free space link 219. In an example embodiment, the free space link 219 may be an optical link, radio frequency link, etc.

According to an example embodiment of the invention, the receiver 220 may communicate with a controller 222 that may further modify, buffer, store, and/or format the information received from the lightning measurement system and transmitter 216. For example the controller 222 may provide alerts, and other information for assessing the severity of the lightning strike, or for assessing the likely damage to components associated with the turbine.

In an example embodiment of the invention, multiple similar lightning measurement systems may communicate with the receiver 220, for example, when there are multiple turbine blades, each with their own lightning measurement system.

According to example embodiments of the invention, the controller 222 may include a memory 224, one or more processors 224, one or more input/output interfaces 228, and one or more network interfaces 230. In an example embodiment, the memory 224 may include an operating system 232, data 234, and one or more lightning modules 236. The one or more lightning modules 237 may include machine-readable code or instructions. In an example embodiment, the lightning modules 236 may be utilized to interpret analog or digital data received by receiver 220 for distinguishing which transmitter sent the signal, the peak lightning strike current, and/or the polarity of the strike.

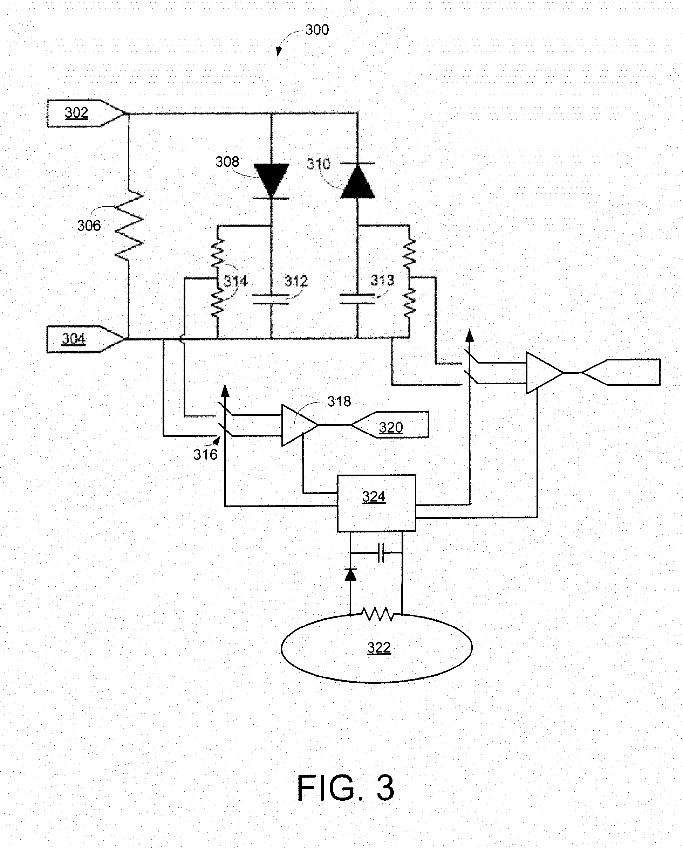

FIG. 3 depicts an example detection circuit 300 that may be associated, for example, with the lightning measurement system and transmitter (as in 216 of FIG. 2). According to an example embodiment, the detection circuit 300 may include connections 302 304 for receiving current associated with the lightning. In an example embodiment, the first input connection 302 may be connected to a down conductor while the second input connection 304 may be connected to ground (or vice versa). In another example embodiment, the connections 302 304 may be connected to either end of a Rogowski coil. In an example embodiment, current flowing through the resistive element 306 may produce a voltage across the resistive element. In an example embodiment, lightning current flowing across the resistive element 306 from the first input connection 302 to the second input connection 304 may produce a positive voltage drop across the resistive element 306, which may be sufficient to forward bias a first diode 308 while reverse biasing a second diode 310. Current flowing through the forward biased diode 308 may charge up capacitor 312, which in an example embodiment, may act as a memory, having a stored voltage related to the peak current of the lightning strike. In an example embodiment, a portion of electromagnetic energy from the lightning strike may activate the lightning detector wake circuit 322, which may provide a wake-up signal for the wake circuit control 324. According to an example embodiment, the wake circuit control 324 may include one or more batteries for powering a relay 316, a differential or operational amplifier 318, and/or other circuitry related to the communication of the stored charge value on capacitor 312.

Conversely, and according to an example embodiment, when the lightning current flow travels from the second input 304 to the first input 302, the second diode 310 may be forward biased and the corresponding capacitor may be charged. According to an example embodiment, the polarity of the lightning strike can therefore be determined by reading and/or comparing the voltage across the storage capacitors.

According to an example embodiment, the capacitor 312 and the resistance of the voltage divider 314 may be chosen so that the RC time constant of the combined components is between about 1 and about 60 seconds. In other example embodiments, the RC time constant can be set to any value that allows the charge on the capacitor 312 to at least partially dissipate through the resistors 314 before the next lightning strike. According to an example embodiment, the RC time constant can be set so that the charge will hold long enough for the voltage across the capacitor to be read after a slight delay to allow EMI to dissipate, as mentioned previously.

In an example embodiment, peak lightning current may be measured using ohms law: E = I*R, where the lightning current (I) generates a voltage (E) across a shunt element having a known resistance (R). In an example embodiment, peak voltage may be measured and peak lightning current may be derived from the peak voltage. In accordance with an example embodiment of the invention, the inductance (L) of the shunt may generate an additional reactive voltage component (E_{R}) related to the lightning current rate of change (for example, E_{R} = dI/dT*L). According to example embodiments of the invention, the rise time of the lightning strike may vary, and thus, any non-zero inductance in the shunt element may add a varying reactive voltage component to the measurement as a function of the current rise time.

According to an example embodiment of the invention, the reactive voltage component may be at least partially eliminated from the measurement by taking a difference measurement between a first and second shunt element having similar geometries, but made from different materials having different resistivities. For example, the resistance R of the shunts may be dominated by bulk material conductivity, but the inductance (L) may be controlled by the shunt geometry. In an example embodiment, a first shunt may be made using NiCr (nichrome), and a second shunt may be made from Copper (Cu). In an example embodiment, the first and second shunts may have the same geometry (and thus similar inductance, L) but since they are made from different materials, the resistance of the shunts may be different. In an example embodiment the voltages generated by the lightning across each shunt in series may be Iₚₑₐₖ*R(Cu)+di/dt*L and Iₚₑₐₖ*R(NiCr)+di/dt*L. In an example embodiment, a voltage may be measured across each shunt element, and a difference may be evaluated to eliminate the inductance and di/dt*L from measurement. According to an example embodiment, the peak current may be determined by knowing the voltage difference and the resistance of the two shunts. In example embodiments, the term shunt may be used to represent a current sense resistive element (bolt, washer, etc.)

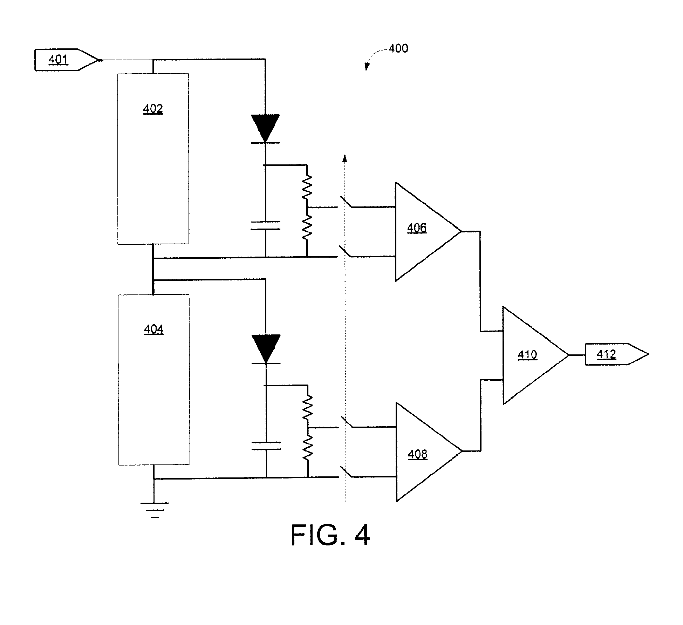

FIG. 4 depicts a differential shunt circuit 400, in accordance with an example embodiment of the invention. According to an example embodiment, lightning current may enter the input 401 and may travel through a series circuit including a first shunt 402 made from a first material (for example copper) and a second shunt 404 made from a second material (for example nichrome). In an example embodiment, the first shunt 402 and the second shunt 404 may have substantially similar geometries and/or inductances, but differing resistances due to the different materials. In an example embodiment, and analogous to the description above with reference to FIG. 2, the lightning current flowing through the resistive elements 402 404 may produce positive voltage drops which may be sufficient to forward bias the diodes.

In an example embodiment, current flowing through forward biased diodes may charge up capacitors, which in an example embodiment, may act as memories, having a stored voltage related to the peak current (and rise time) of the lightning strike. In an example embodiment, a portion of electromagnetic energy from the lightning strike may activate a lightning detector wake circuit that may provide signals for switches or relays to complete circuits with a first 406 and second 408 differential (or operational) amplifier, thereby presenting the voltage charge from the capacitors to the inputs of the differential amplifiers 406 408. In an example embodiment, the output signals from the differential amplifiers 406 408 may provide input to a third differential (or operational) amplifier 410, which may, according to an example embodiment, provide a difference signal for presentation at the output 412, where the lightning rise time-induced voltage component (due to inductance) has been effectively cancelled out.

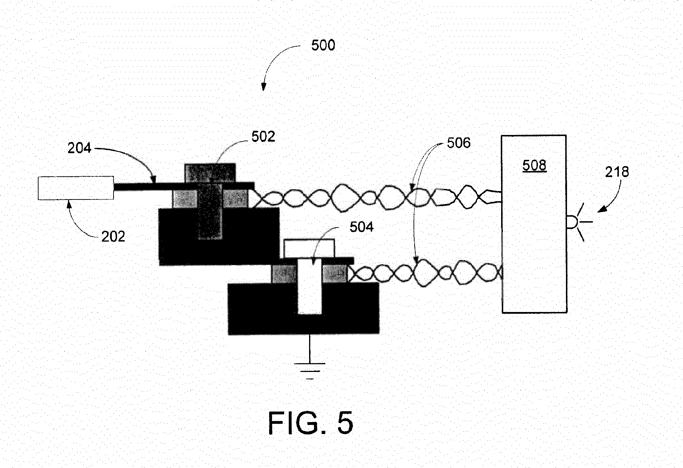

FIG. 5 depicts an example shunt detection circuit, according to an example embodiment of the invention. In this example embodiment, lightning current may flow through a first shunt 502 (having a first material, for example, Cu). In an example embodiment, the lightning current may then flow though a second shunt 504 (having a second material, for example NiCr). In accordance with an example embodiment, voltage drops across the two shunts 502 504 may be communicated to a differential lightning measurement system and transmitter 508 by twisted pair 506. According to an example embodiment, the differential lightning measurement system and transmitter 508 may provide part of the switching, storage, and difference functionality as described above with reference to FIG 4.

In accordance with certain example embodiments of the invention, and as discussed, lightning strike classification information such as the peak current, polarity, and location of the lightning strike may be determined by embodiments of the invention.

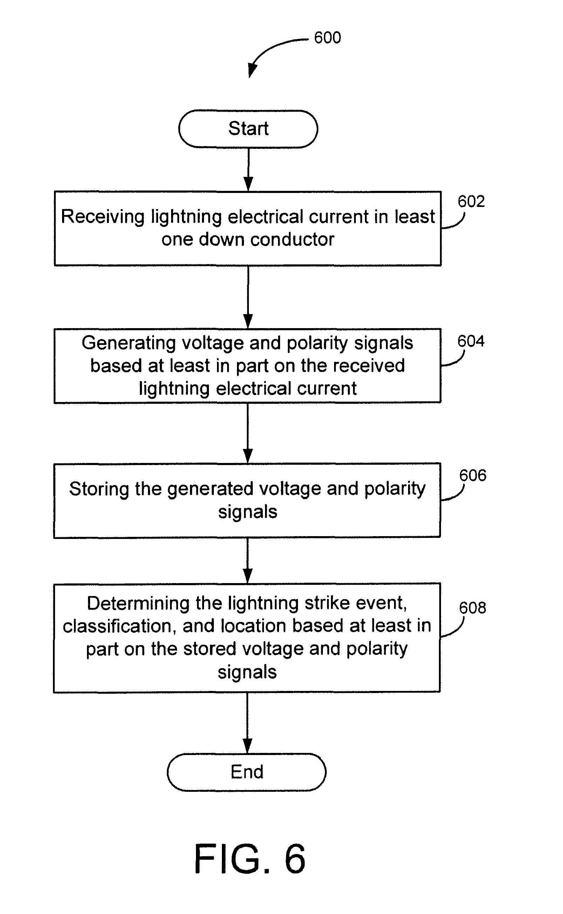

An example method 600 for determining a lightning strike event, classification, and location will now be described with reference to the flowchart of FIG. 6. The method 600 starts in block 602, and according to an example embodiment of the invention, includes receiving lightning electrical current in least one down conductor. In block 604, and according to an example embodiment, the method includes generating voltage and polarity signals based at least in part on the received lightning electrical current. In block 606, and according to an example embodiment, the method includes storing the generated voltage and polarity signals. In block 608, and according to an example embodiment, the method includes determining the lightning strike event, classification, and location based at least in part on the stored voltage and polarity signals. Method 600 ends after block 608.

According to example embodiments of the invention, voltage and/or polarity signals may be generated based at least in part on the received lightning electrical current. In an example embodiment, the voltage and/or polarity signals may be generated by conducting the current through at least one resistive element. In example embodiments, the resistive element may include (but is not limited to) a bolt, shunt, rod, or washer. In an example embodiment, at least a portion of the resistive element can include a material such as Nichrome.

According to example embodiments, voltage and/or polarity signals may be generated based at least in part on the received lightning electrical current, where the current may be induced in a Rogowski coil placed around or near the down conductor. In an example embodiment, the voltage may be generated across a resistive element in series with the Rogowski coil.

Example embodiments of the invention may include activating at least one voltage measurement circuit in response to an induced electromagnetic field associated with the lightning strike event. Example embodiments of the invention may include measuring the stored voltage and polarity signals with the at least one voltage measurement circuit after the lightning strike event. Example embodiments of the invention may include converting the stored voltage and polarity signals to an optical signal. Example embodiments of the invention may include transmitting the optical signal to an optical receiver. Example embodiments of the invention may include de-activating the at least one voltage measurement circuit. Example embodiments of the invention may include converting the stored voltage and polarity signals comprises one or more of measuring, filtering, and digitizing the voltage and polarity signals. Example embodiments of the invention may include at least one down conductor is associated with a wind turbine blade. Example embodiments of the invention may include an electrical to optical converter configured for transmitting the optical signal to the optical receiver. Example embodiments of the invention may include at least one diode for rectifying the voltage signal.

Example embodiments of the invention may include at least one differential amplifier for sensing the stored voltage and polarity signals. Example embodiments of the invention may include at least one analog to digital converter for digitizing the sensed voltage and polarity signals. Example embodiments of the invention may include at least one circuit configured for activating and de-activating the at least one differential amplifier and the at least one analog to digital converter in response to an induced electromagnetic field associated with the lightning strike event.

Accordingly, example embodiments of the invention can provide the technical effects of creating certain systems, methods, and apparatus that can detect a lightning strike event, and provide classification and location information about the lightning strike. Example embodiments of the invention can provide the further technical effects of providing systems, methods, and apparatus for waking power circuits from low current draw states in response to a lightning strike. Example embodiments of the invention can provide the further technical effects of providing systems, methods, and apparatus for detecting a lightning strike and providing classification and location information about the lightning strike using battery power for at least part of the system.

In example embodiments of the invention, the example lightning detection system 200 and the example detection circuit 300 may include any number of hardware and/or software applications that are executed to facilitate any of the operations.

In example embodiments, one or more I/O interfaces may facilitate communication between the example lightning detection system 200 and the example detection circuit 300, and one or more input/output devices. For example, a universal serial bus port, a serial port, a disk drive, a CD-ROM drive, and/or one or more user interface devices, such as a display, keyboard, keypad, mouse, control panel, touch screen display, microphone, etc., may facilitate user interaction with the example lightning detection system 200 and the example detection circuit 300. The one or more I/O interfaces may be utilized to receive or collect data and/or user instructions from a wide variety of input devices. Received data may be processed by one or more computer processors as desired in various embodiments of the invention and/or stored in one or more memory devices.

One or more network interfaces may facilitate connection of the example lightning detection system 200 and the example detection circuit 300 inputs and outputs to one or more suitable networks and/or connections; for example, the connections that facilitate communication with any number of sensors associated with the system. The one or more network interfaces may further facilitate connection to one or more suitable networks; for example, a local area network, a wide area network, the Internet, a cellular network, a radio frequency network, a Bluetooth™ (Owned by Telefonaktiebolaget LM Ericsson) enabled network, a Wi-Fi™ (owned by Wi-Fi Alliance) enabled network, a satellite-based network any wired network, any wireless network, etc., for communication with external devices and/or systems.

As desired, embodiments of the invention may include the example lightning detection system 200 and the example detection circuit 300 with more or less of the components illustrated in FIGs. 2 and 3.

The invention is described above with reference to block and flow diagrams of systems, methods, apparatuses, and/or computer program products according to example embodiments of the invention. It will be understood that one or more blocks of the block diagrams and flow diagrams, and combinations of blocks in the block diagrams and flow diagrams, respectively, can be implemented by computer-executable program instructions. Likewise, some blocks of the block diagrams and flow diagrams may not necessarily need to be performed in the order presented, or may not necessarily need to be performed at all, according to some embodiments of the invention.

These computer-executable program instructions may be loaded onto a general-purpose computer, a special-purpose computer, a processor, or other programmable data processing apparatus to produce a particular machine, such that the instructions that execute on the computer, processor, or other programmable data processing apparatus create means for implementing one or more functions specified in the flow diagram block or blocks. These computer program instructions may also be stored in a computer-readable memory that can direct a computer or other programmable data processing apparatus to function in a particular manner, such that the instructions stored in the computer-readable memory produce an article of manufacture including instruction means that implement one or more functions specified in the flow diagram block or blocks. As an example, embodiments of the invention may provide for a computer program product, comprising a computer-usable medium having a computer-readable program code or program instructions embodied therein, said computer-readable program code adapted to be executed to implement one or more functions specified in the flow diagram block or blocks. The computer program instructions may also be loaded onto a computer or other programmable data processing apparatus to cause a series of operational elements or steps to be performed on the computer or other programmable apparatus to produce a computer-implemented process such that the instructions that execute on the computer or other programmable apparatus provide elements or steps for implementing the functions specified in the flow diagram block or blocks.

Accordingly, blocks of the block diagrams and flow diagrams support combinations of means for performing the specified functions, combinations of elements or steps for performing the specified functions and program instruction means for performing the specified functions. It will also be understood that each block of the block diagrams and flow diagrams, and combinations of blocks in the block diagrams and flow diagrams, can be implemented by special-purpose, hardware-based computer systems that perform the specified functions, elements or steps, or combinations of special-purpose hardware and computer instructions.

While the invention has been described in connection with what is presently considered to be the most practical and various embodiments, it is to be understood that the invention is not to be limited to the disclosed embodiments, but on the contrary, is intended to cover various modifications and equivalent arrangements included within the scope of the appended claims. Although specific terms are employed herein, they are used in a generic and descriptive sense only and not for purposes of limitation.

This written description uses examples to disclose the invention, including the best mode, and also to enable any person skilled in the art to practice the invention, including making and using any devices or systems and performing any incorporated methods. The patentable scope of the invention is defined in the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

For completeness, various aspects of the invention are now set out in the following numbered clauses:
1. A method for determining a lightning strike event, classification, and location comprising:
   receiving lightning electrical current in at least one down conductor;
   generating voltage and polarity signals based at least in part on the received lightning electrical current;
   storing the generated voltage and polarity signals; and
   determining the lightning strike event, classification, and location based at least in part on the stored voltage and polarity signals.
2. The method of clause 1, wherein generating a voltage and polarity signals based at least in part on the received lightning electrical current comprises conducting the current through at least one resistive element comprising at least one of the following: a bolt, shunt, or washer.
3. The method of clause 2, wherein at least a portion of the bolt, shunt, or washer comprises Nichrome.
4. The method of clause 1, wherein generating a voltage and polarity signals based at least in part on the received lightning electrical current comprises inducing a current in a Rogowski coil placed around or near the down conductor and generating a voltage across a resistive element in series with the Rogowski coil.
5. The method of clause 1, further comprising:
   activating at least one voltage measurement circuit in response to an induced electromagnetic field associated with the lightning strike event;
   measuring the stored voltage and polarity signals with the at least one voltage measurement circuit after the lightning strike event;
   converting the stored voltage and polarity signals to an optical signal;
   transmitting the optical signal to an optical receiver; and
   de-activating the at least one voltage measurement circuit.
6. The method of clause 5, wherein converting the stored voltage and polarity signals comprises one or more of measuring, filtering, and digitizing the voltage and polarity signals.
7. The method of clause 1, wherein the at least one down conductor is associated with a wind turbine blade.
8. A system for determining a lightning strike event, classification, and location, the system comprising:
   at least one wind turbine blade;
   a down conductor associated with the at least one wind turbine blade and operable for receiving lightning electrical current;
   a resistive element configured for producing voltage and polarity signals from the lightning electrical current;
   at least one capacitive element configured for storing the voltage and polarity signals;
   an electrical to optical converter configured to produce an optical signal based at least in part on the stored voltage and polarity signals; and
   an optical receiver for receiving the optical signal.
9. The system of clause 8, wherein the resistive element comprises a bolt, shunt, or washer.
10. The system of clause 8, wherein the resistive element comprises Nichrome.
11. The system of clause 8, wherein the electrical to optical converter is configured for transmitting the optical signal to the optical receiver.
12. The system of clause 8, further comprising at least one diode for rectifying the voltage signal.
13. The system of clause 8 further comprising:
   at least one differential amplifier for sensing the stored voltage and polarity signals;
   at least one analog to digital converter for digitizing the sensed voltage and polarity signals; and
   at least one circuit configured for activating and de-activating the at least one differential amplifier and the at least one analog to digital converter in response to an induced electromagnetic field associated with the lightning strike event.
14. An apparatus for determining a lightning strike event, classification, and location, the apparatus comprising:
   a down conductor associated operable for receiving lightning electrical current;
   a resistive element configured for producing voltage and polarity signals from the lightning electrical current;
   at least one capacitive element configured for storing the voltage and polarity signals;
   an electrical to optical converter configured to produce an optical signal based at least in part on the stored voltage and polarity signals; and
   an optical receiver for receiving the optical signal.
15. The apparatus of clause 14, wherein the resistive element comprises a bolt, shunt, or washer.
16. The apparatus of clause 14, wherein resistive element comprises Nichrome.
17. The apparatus of clause 14, wherein the electrical to optical converter is configured for transmitting the optical signal to the optical receiver.
18. The apparatus of clause 14, further comprising at least one diode for rectifying the voltage signal.
19. The apparatus of clause 14 further comprising:
   at least one differential amplifier for sensing the stored voltage and polarity signals;
   at least one analog to digital converter for digitizing the sensed voltage and polarity signals; and
   at least one circuit configured for activating and de-activating the at least one differential amplifier and the at least one analog to digital converter in response to an induced electromagnetic field associated with the lightning strike event.
20. The apparatus of clause 14, wherein resistive element is about 0.5 to about 1.5 cm in length and about 0.4 to about 1.4 cm in diameter.
21. A method for determining a lightning strike event, classification, and location comprising:
   receiving lightning electrical current in the at least one down conductor;
   conducting the received lightning electrical current through a series circuit comprising a first shunt having a first resistivity and a second shunt having a second resistivity, wherein the first and second resistivities are unequal;
   generating a first voltage signal and a second voltage signal from the first shunt and the second shunt respectively based at least in part on the received lightning electrical current;
   measuring a difference signal between the first voltage signal and the second voltage signal;
   determining the lightning strike event, classification, and location based at least in part on the measured difference signal.
22. The method of clause 21, wherein generating the first voltage signal and the second voltage signal comprises conducting the received lightening current through the first shunt and the second shunt elements, wherein the first shunt and the second shunt elements comprise substantially equal geometries or inductances.

## Claims

1. A method for determining a lightning strike event, classification, and location **characterised by**:
receiving lightning electrical current in at least one down conductor;
generating voltage and polarity signals based at least in part on the received lightning electrical current;
storing the generated voltage and polarity signals; and
determining the lightning strike event, classification, and location based at least in part on the stored voltage and polarity signals.

2. The method of claim 1, wherein generating a voltage and polarity signals based at least in part on the received lightning electrical current comprises conducting the current through at least one resistive element comprising at least one of the following: a bolt, shunt, or washer.

3. The method of claim 1 or claim 2, wherein at least a portion of the bolt, shunt, or washer comprises Nichrome.

4. The method of any preceding claim, wherein generating a voltage and polarity signals based at least in part on the received lightning electrical current comprises inducing a current in a Rogowski coil placed around or near the down conductor and generating a voltage across a resistive element in series with the Rogowski coil.

5. The method of any preceding claim, further **characterised by**:
activating at least one voltage measurement circuit in response to an induced electromagnetic field associated with the lightning strike event;
measuring the stored voltage and polarity signals with the at least one voltage measurement circuit after the lightning strike event;
converting the stored voltage and polarity signals to an optical signal;
transmittting the optical signal to an optical receiver; and
de-activating the at least one voltage measurement circuit.

6. The method of claim 5, wherein converting the stored voltage and polarity signals comprises one or more of measuring, filtering, and digitizing the voltage and polarity signals.

7. The method of any preceding claim, wherein the at least one down conductor is associated with a wind turbine blade.

8. An apparatus for determining a lightning strike event, classification, and location, the apparatus comprising:
a down conductor associated operable for receiving lightning electrical current;
a resistive element configured for producing voltage and polarity signals from the lightning electrical current;
at least one capacitive element configured for storing the voltage and polarity signals;
an electrical to optical converter configured to produce an optical signal based at least in part on the stored voltage and polarity signals; and
an optical receiver for receiving the optical signal.

9. The apparatus of claim 8, wherein the resistive element comprises a bolt, shunt, or washer.

10. The apparatus of claim 8 or claim 9, wherein resistive element comprises Nichrome.

11. The apparatus of any one of claims 8 to 10, wherein the electrical to optical converter is configured for transmitting the optical signal to the optical receiver.

12. The apparatus of any one of claims 8 to 11, further comprising at least one diode for rectifying the voltage signal.

13. The apparatus of any one of claims 8 to 12, further comprising:
at least one differential amplifier for sensing the stored voltage and polarity signals;
at least one analog to digital converter for digitizing the sensed voltage and polarity signals; and
at least one circuit configured for activating and de-activating the at least one differential amplifier and the at least one analog to digital converter in response to an induced electromagnetic field associated with the lightning strike event.

14. A system for determining a lightning strike event, classification, and location, the system comprising:
at least one wind turbine blade; and
the apparatus of any one of claims 8 to 13, wherein the down conductor is associated with the at least one wind turbine blade.

15. The method of claim 1, comprising:
receiving lightning electrical current in the at least one down conductor;
conducting the received lightning electrical current through a series circuit comprising a first shunt having a first resistivity and a second shunt having a second resistivity, wherein the first and second resistivities are unequal;
generating a first voltage signal and a second voltage signal from the first shunt and the second shunt respectively based at least in part on the received lightning electrical current;
measuring a difference signal between the first voltage signal and the second voltage signal;
determining the lightning strike event, classification, and location based at least in part on the measured difference signal.
